# DEMANDE DE BREVET EUROPEEN

(11) **EP 1 420 443 A2**
(43) Date de publication de la demande: **19.05.2004**
(21) Numéro de dépôt: 03292536.4
(22) Date de dépôt: 13.10.2003
(51) Int. Cl.: H01L 21/768

(54) **Dispositif de connexion électrique entre deux pistes d'un circuit integré**

(30) Priorité: 14.11.2002 FR 0214242
(71) Demandeur: STMicroelectronics S.A., 92120 Montrouge (FR); Koninklijke Philips Electronics N.V., 5621 BA Eindhoven (NL)
(72) Inventeur: Kordic, Srdjan, 38190 Bernin (FR); Roussel, Céline, 38400 St. Martin d'Heres (FR); Inard, Alain, 38330 St Nazaire les Eymes (FR)
(74) Mandataire: Loisel, Bertrand

(57) **Abrégé**

Un dispositif de connexion électrique entre deux pistes conductrices (1, 2) d'un circuit intégré comprend un premier raccord conducteur (3a) entre les deux pistes. Le dispositif comprend en outre une interface supplémentaire (3b-3g ; 6a-6f) de l'une des deux pistes, distincte de l'interface de la piste avec le premier raccord et distincte de l'interface latérale de la piste avec un matériau isolant parallèlement à la direction de passage du courant électrique dans la piste. L'interface supplémentaire est disposée à une distance du premier raccord sensiblement inférieure à la largeur de la piste. L'interface supplémentaire peut être obtenue en disposant au moins un second raccord conducteur (3b-3g) entre les deux pistes, ou en disposant au moins une nervure dans la piste (6a-6f), ou en disposant des créneaux sur une au moins des faces de la piste.

## Description

La présente invention concerne un dispositif de connexion électrique entre deux pistes conductrices d'un circuit électrique, plus particulièrement d'un circuit électronique intégré.

Dans un circuit électronique intégré réalisé à la surface d'un substrat, il est souvent nécessaire de connecter électriquement entre elles deux pistes conductrices disposées dans des plans parallèles superposés s'étendant au dessus de la surface du substrat. Pour cela, les pistes sont disposées de manière que leurs projections respectives sur la surface du substrat présentent des portions communes, notamment lorsque les pistes se croisent. Un raccord conducteur est alors disposé entre les deux pistes, qui réalise une connexion électrique entre les deux pistes selon la direction perpendiculaire à la surface du substrat.

Un tel raccord est connu sous le vocable «via», dans le jargon de l'Homme du métier. Un «via» comprend une partie sensiblement cylindrique d'axe perpendiculaire à la surface du substrat, qui est en contact avec chacune des deux pistes. Cette partie cylindrique présente des dimensions particulièrement réduites : de l'ordre de 0,1 micromètre de section au niveau de l'interface avec chaque piste, parallèlement à la surface du substrat, et de l'ordre de 0,5 micromètre de long suivant la direction perpendiculaire à la surface du substrat. Ces dimensions sont liées au procédé de réalisation du raccord.

Les pistes conductrices sont constituées d'un matériau métallique, tel que le cuivre ou l'aluminium par exemple. La densité de ces pistes est souvent inférieure à la densité théorique du même matériau massif, si bien que les pistes peuvent être sujettes à une contraction de leur matériau constitutif, causée notamment par des phénomènes thermiques, en particulier par un chauffage. De tels phénomènes se produisent notamment lors de la fabrication du circuit électrique ou ultérieurement, lors de l'utilisation du circuit. Cette contraction peut provoquer la formation d'un trou dans la piste. Typiquement, un tel trou se forme au niveau de l'interface entre le raccord et la piste. La continuité électrique entre les deux pistes peut alors être rompue, ce qui peut empêcher le fonctionnement correct du circuit électrique. Dans certains cas, la continuité électrique n'est pas rompue, mais la résistance électrique entre le raccord et la piste est augmentée par la présence du trou. La fiabilité du circuit électrique est alors réduite, notamment à cause d'effets d'électromigration.

Plus précisément, à l'issue de la réalisation des pistes, le matériau des pistes présente une porosité, si bien que des vides élémentaires sont présents d'une façon répartie au sein du matériau. Ces vides élémentaires peuvent être en particulier des trous de porosité, ou encore des lacunes de structure du matériau à l'échelle atomique. Des vides élémentaires peuvent aussi être engendrés par des contraintes dans le matériau des pistes qui résultent de dilatations différentielles entre le matériau des pistes et un matériau externe aux pistes, notamment un matériau isolant au sein duquel les pistes sont disposées. De tels vides élémentaires apparaissent notamment lorsque le matériau des pistes et le matériau isolant ont des coefficients de dilatation thermique respectifs différents. D'autres types de vides élémentaires peuvent être présents, mais leur nature et leur origine sont parfois difficilement identifiables.

Il a été observé que les vides élémentaires présentent une certaine mobilité au sein du matériau conducteur des pistes, et notamment qu'ils se déplacent pour se regrouper en des sites préférentiels, et forment à cet endroit un vide de taille supérieure. Des sites de regroupement des vides élémentaires de l'une des pistes sont par exemple des jonctions entre des grains du matériau de la piste, ou des endroits de la surface de cette piste qui présentent des contraintes locales particulièrement élevées. C'est en particulier le cas au niveau d'une arrête appartenant à une interface entre une piste et un matériau entourant la piste, plus dur et/ou plus élastique que le matériau de la piste elle-même, ou au niveau d'une interface de dimension réduite entre la piste et un matériau externe à la piste, distinct du matériau entourant la piste.

L'interface entre un raccord et une piste est donc un site privilégié de regroupement de vides élémentaires. Par conséquent, un vide de dimensions comparables à la section du raccord peut apparaître à cette interface. Lorsqu'une grande quantité de vides élémentaires participe à la formation d'un vide localisé à l'interface avec le raccord, le contact électrique entre le raccord et la piste peut être rompu. Cette perte du contact électrique intervient d'autant plus rapidement que la dimension du raccord est faible, notamment pour les circuits électroniques à haut niveau d'intégration, et d'autant plus rapidement que la piste est large, et donc susceptible de contenir un grand nombre de vides élémentaires.

Un but de la présente invention consiste à réduire la probabilité de formation d'un vide à l'interface entre un raccord et une piste conductrice.

L'invention propose ainsi un dispositif de connexion électrique entre une première piste conductrice et une seconde piste conductrice d'un circuit électrique intégré, qui comprend un premier raccord conducteur entre la première piste et la seconde piste. La première piste présente une première interface avec le premier raccord et une seconde interface avec un matériau isolant entourant latéralement la première piste, ladite seconde interface étant sensiblement parallèle à une direction de passage d'un courant électrique dans la première piste. La première piste comprend en outre au moins une interface supplémentaire avec un matériau externe à la première piste et au premier raccord, disposée à une distance du premier raccord sensiblement inférieure à une largeur de la première piste au niveau de la première interface. De façon classique, la largeur d'une piste est mesurée suivant une direction perpendiculaire à la direction de passage du courant dans la piste, et parallèle à la surface du substrat.

Ainsi, le dispositif de connexion électrique présente une ou plusieurs interfaces supplémentaires sur lesquelles peuvent se regrouper des vides élémentaires présents au sein de la première piste. Les vides élémentaires se répartissent alors entre des sites plus nombreux, au niveau de l'interface ou des interfaces supplémentaires en plus de l'interface entre ledit premier raccord et la première piste, si bien que le vide qui peut se former au niveau dudit premier raccord est de taille réduite. Il en résulte que la probabilité de rupture de la continuité électrique entre les deux pistes diminue, et ce d'autant plus les dimensions de l'interface supplémentaire sont grandes. La fiabilité du circuit est alors accrue.

Cette diminution de la probabilité de rupture de la continuité électrique entre les deux pistes a été observée lorsque l'interface ou les interfaces supplémentaires sont disposées à proximité dudit premier raccord. Une distance entre l'une au moins des interfaces supplémentaires et le premier raccord inférieure à une largeur de la première piste au niveau du premier raccord est apparue préférable pour observer une diminution sensible de ladite probabilité.

L'interface supplémentaire ajoutée selon l'invention peut être d'au moins deux natures distinctes. Selon un premier mode de réalisation, l'interface supplémentaire est obtenue par ajout d'un second raccord conducteur entre les deux pistes. Il s'agit alors d'une interface entre ladite première piste et le second raccord. Si cette interface est de faibles dimensions, elle constitue un site privilégié de regroupement des vides élémentaires. En particulier, les premier et second raccords peuvent être identiques, c'est-à-dire être formés d'un même matériau et présenter des dimensions sensiblement égales. Les probabilités respectives de diffusion d'un vide élémentaire donné vers l'interface de l'un des deux raccords avec la piste sont alors égales chacune à la moitié de la probabilité de diffusion de ce vide élémentaire vers l'interface avec le premier raccord dans une configuration où seul le premier raccord est présent. La probabilité de perte du contact électrique entre la piste et le premier raccord est alors réduite de façon correspondante.

Selon un second mode de réalisation, l'interface supplémentaire est une interface entre la première piste et un matériau isolant. Une telle interface supplémentaire peut en particulier être obtenue par ajout de motifs au niveau de ladite seconde interface. De tels motifs constituent des portions d'interface supplémentaires par rapport à ladite seconde interface. Ladite seconde interface étant sensiblement parallèle à une direction de passage d'un courant électrique dans la première piste, les portions d'interface supplémentaires peuvent être orientées différemment. Ces portions d'interface supplémentaires entre la piste et le matériau isolant forment des sites supplémentaires de regroupement des vides élémentaires. De la même façon que dans le premier mode de réalisation, la probabilité de perte du contact électrique entre la piste et le premier raccord est donc réduite.

D'autres particularités et avantages de la présente invention apparaîtront dans la description ci-après d'exemples de réalisation non limitatifs, en référence aux dessins annexés, dans lesquels :
- la figure 1 est une vue en perspective d'un dispositif de connexion entre deux pistes conductrices selon l'art antérieur ;
- la figure 2 est une vue en perspective d'un dispositif de connexion entre deux pistes conductrices selon un premier mode de réalisation de la présente invention ;
- la figure 3 représente un dispositif de connexion entre deux pistes conductrices selon un second mode de réalisation de la présente invention ;
- la figure 4 représente un dispositif de connexion entre deux pistes conductrices selon une combinaison des premier et second modes de réalisation ;
- la figure 5 représente une variante du dispositif de connexion de la figure 4 ;
- la figure 6 représente un dispositif de connexion entre deux pistes conductrices selon un troisième mode de réalisation de la présente invention ;
- la figure 7 représente une variante du dispositif de connexion de la figure 6.

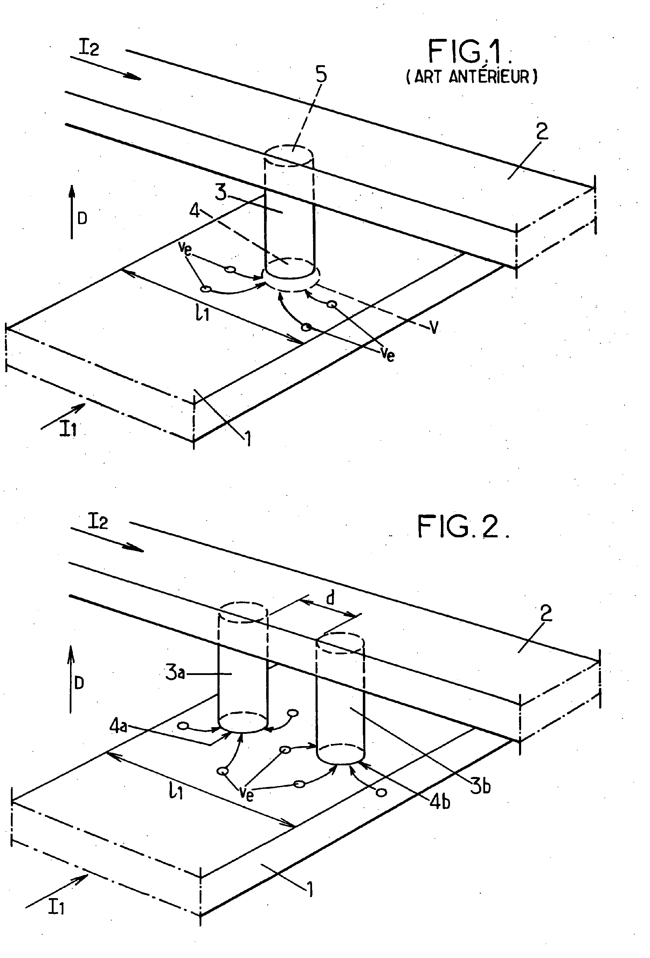

Pour raison de clarté, les dimensions des différentes parties de circuits représentées sur les figures ne sont pas en proportion avec des dimensions réelles. Des références identiques indiquées sur plusieurs figures correspondent à des éléments identiques. Les termes «supérieur», «inférieur», «sur» et «sous» utilisés dans la suite sont définis en référence à une direction D commune indiquée sur les figures 1 et 2, perpendiculaire aux pistes.

Selon la figure 1 relative à un dispositif selon l'art antérieur, une connexion entre deux pistes 1 et 2 est réalisée au moyen d'un raccord 3, ou «via». Les pistes 1 et 2 sont, par exemple, chacune rectilignes et disposées à des niveaux différents selon la direction D. Les deux pistes 1 et 2 peuvent chacune présenter des sections rectangulaires dans des plans perpendiculaires à des directions respectives de passage de courants électriques I1 et I2 dans chaque piste. Elles ont une largeur de l'ordre de 0,1 à 20 micromètres, et une épaisseur (selon la direction D) de l'ordre de 0,5 micromètre. Les pistes 1 et 2 ne sont pas en contact entre elles, mais ont des portions respectives superposées entre elles selon la direction D. Le raccord 3 est par exemple constitué d'un cylindre d'axe parallèle à la direction D, disposé entre lesdites portions de pistes superposées. Le raccord 3 est ainsi en contact avec la piste 1 par une interface 4 située sur la face supérieure de la piste 1, et avec la piste 2 par une interface 5 située sur la face inférieure de la piste 2. La largeur I₁ indiquée sur la figure 1 est la largeur de la piste 1 au niveau de l'interface 4.

Les pistes 1 et 2 et le raccord 3 peuvent être réalisés selon la méthode «Damascène», bien connue de l'Homme du métier. Dans cette méthode, les pistes 1 et 2, ainsi que le raccord 3 sont réalisés au sein de couches de matériau isolant superposées selon la direction D au dessus d'un substrat (non représenté) sensiblement plan. Pour cela, chaque couche est gravée au travers d'un masque de lithographie qui présente une ouverture correspondant à une section, dans un plan perpendiculaire à la direction D, de l'un des éléments parmi la piste 1, le raccord 3 et la piste 2. Des volumes ainsi gravés sont remplis de matériau métallique, en utilisant un procédé qui comprend, par exemple, une étape de dépôt électrolytique, connue de l'Homme du métier. Le masque est retiré, et un polissage est effectué pour éliminer un excès de matériau métallique déposé. La couche suivante de matériau isolant est ensuite réalisée.

Les pistes et raccords ainsi réalisés sont disposés au sein du matériau isolant électrique des différentes couches. Ce matériau isolant peut être de composition chimique quelconque. Il peut notamment comprendre des atomes de silicium combinés avec d'autres atomes, par exemple d'oxygène, de carbone, de fluor, etc, de façon à lui conférer un comportement électrique isolant. En particulier, ce peut être de la silice. Le matériau isolant peut aussi être un matériau organique ou à base d'atomes de carbone, tel que, par exemple, un composé comprenant des atomes de carbone et de fluor, connu sous l'appellation de «téflon».

Les pistes 1 et 2 sont constituées d'un matériau métallique, pouvant être, par exemple, à base de cuivre, d'aluminium, d'argent ou d'un alliage contenant l'un au moins des métaux précédents. Lorsque ce matériau métallique est déposé de la façon citée précédemment, il présente une densité inférieure à la densité théorique du même matériau massif («bulk density»). A titre d'exemple, la densité réelle est de l'ordre de 83 % à 98,6 % de sa densité théorique. Des vides élémentaires, désignés par vₑ sur la figure 1, sont donc présents, au sein de la piste 1 par exemple, qui peuvent diffuser et se regrouper en des endroits particuliers, et forment alors un vide de dimension supérieure à cet endroit. L'interface 4 est un tel endroit de regroupement des vides élémentaires vₑ, si bien qu'un vide plus grand, noté V sur la figure 1, peut se développer à partir de l'interface 4. La résistance électrique entre la piste 1 et le raccord 3 est alors augmentée, et, si le vide V est de dimension suffisante par rapport à l'interface 4, il provoque une rupture du contact électrique entre la piste 1 et le raccord 3.

Différents exemples de modes de mise en oeuvre de l'invention sont décrits ci-dessous. Ils comprennent les éléments de la figure 1, et sont obtenus suivant le procédé de fabrication correspondant. Chacun de ces modes de mise en oeuvre correspond à une modification de la configuration du dispositif de connexion de la figure 1, en vue de réduire le volume vide V par rapport à la dimension de ce volume vide V dans cette configuration.

La figure 2 illustre un premier exemple de mode de mise en oeuvre de l'invention. Selon ce premier mode de mise en oeuvre, deux raccords 3a et 3b, chacun identique au raccord 3 de la figure 1, sont disposés à proximité l'un de l'autre selon une largeur de la piste 1. Il peut être éventuellement nécessaire d'augmenter pour cela la largeur de la piste 1 au niveau des raccords 3a et 3b. La distance d de séparation des deux raccords 3a et 3b est alors inférieure à la largeur I₁ de la piste 1. Les deux interfaces 4a et 4b, respectivement des raccords 3a et 3b avec la piste 1, constituent chacune un endroit particulier de regroupement des vides élémentaires vₑ, si bien que chaque vide élémentaire vₑ diffuse soit vers l'interface 4a, soit vers l'interface 4b. Des volumes vides résultant, respectivement au niveau de chacune des interfaces 4a et 4b, se développent alors avec une vitesse de croissance moitié de celle obtenue pour la configuration de connexion électrique de la figure 1, si bien qu'ils atteignent des tailles définitives de dimensions inférieures. Le risque de perte de la continuité électrique entre les pistes 1 et 2 est réduit. Ce risque est quasiment supprimé lorsque ces dimensions sont suffisamment petites.

Pour réduire encore le risque de perte de la continuité électrique entre les pistes 1 et 2, plus de deux raccords peuvent être disposés entre les pistes 1 et 2. En particulier, les raccords peuvent être répartis à la fois selon la largeur de la piste 1 et selon la direction I1 du passage du courant électrique dans la piste 1.

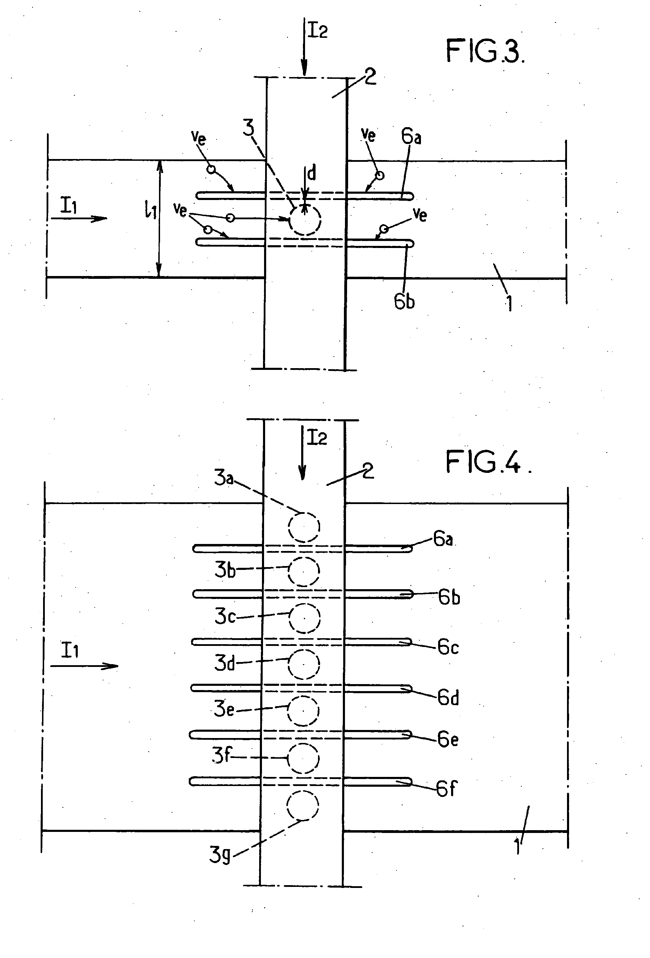

La figure 3 illustre un second mode de mise en oeuvre de l'invention. Selon ce second mode de mise en oeuvre, deux nervures 6a et 6b constituées d'un matériau isolant sont disposées dans la piste 1, parallèlement à la direction de passage de courant I1. Il s'agit par exemple du même matériau que celui qui entoure la piste 1 Les nervures 6a et 6b sont par exemple disposées de part et d'autre du raccord 3, sur la même face supérieure de la piste 1 que le raccord 3. Pour obtenir une efficacité maximale, le raccord 3 est situé approximativement au niveau du milieu des nervures 6a et 6b.

La surface des nervures 6a et 6b constitue une interface supplémentaire au sens de la présente invention. La distance d entre le raccord 3 et la nervure 6a est inférieure à la largeur I₁ de la piste 1.

Etant donné que certains des vides élémentaires vₑ présents dans la piste 1 peuvent diffuser vers des sites de regroupement situés à la surface des nervures 6a et 6b, la quantité de vides élémentaires qui atteignent l'interface entre le raccord 3 et la piste 1 est réduite par rapport à la configuration de la figure 1.

Eventuellement, une seule des deux nervures est suffisante pour obtenir l'effet de l'invention. Toutefois, le résultat est plus satisfaisant encore avec deux nervures disposées chacune de part et d'autre du raccord 3.

Selon une amélioration du second mode de mise en oeuvre, les nervures 6a et 6b traversent la piste 1 entre ses faces supérieure et inférieure. Dans ce cas, un vide élémentaire vₑ initialement présent dans la piste 1 d'un côté de l'une des deux nervures opposé au raccord 3 ne peut pas diffuser jusqu'à atteindre l'interface entre le raccord 3 et la piste 1. On obtient ainsi une réduction du volume de la piste 1 dont peuvent provenir des vides élémentaires qui atteignent l'interface du raccord 3 avec la piste 1. Une diminution supplémentaire de la probabilité de rupture de la continuité électrique entre les pistes 1 et 2 est ainsi obtenue.

Le dispositif de connexion de la figure 4 correspond à une combinaison des dispositifs des figures 2 et 3. Plus de deux nervures du matériau isolant qui entoure la piste 1, par exemple six nervures 6a-6f, pénètrent dans la piste 1 à intervalles réguliers selon la largeur de la piste 1. Les six nervures 6a-6f sont chacune parallèles à la direction I1. Les nervures 6a-6f peuvent être identiques entre elles. Un raccord 3a est alors disposé entre un premier bord de la surface supérieure de la piste 1 et la nervure 6a, des raccords 3b-3f sont disposés respectivement entre deux nervures successives, et le raccord 3g est disposé entre la nervure 6f et le second bord de la face supérieure de la piste 1. Le gain en terme de diminution de la probabilité de rupture de la continuité électrique entre les pistes 1 et 2 est alors une combinaison des gains correspondant respectivement aux configurations des figures 2 et 3.

Eventuellement, la largeur totale de la piste 1 peut être augmentée localement au niveau des nervures 6a-6f de façon à compenser les sections des nervures perpendiculairement à la direction I1. Un tel arrangement permet d'obtenir une section constante de passage du courant électrique sur toute la longueur de la piste 1. Il évite alors l'apparition d'échauffements causés par une densité de courant localement supérieure, qui favoriseraient la diffusion des vides élémentaires.

Plusieurs raccords entre les pistes 1 et 2 peuvent aussi être disposés entre deux nervures adjacentes ou entre une nervure et un bord de la face supérieure de la piste 1. Préférentiellement, de tels raccords sont alignés selon la direction I1, et la largeur de la piste 2 peut être localement adaptée de façon correspondante.

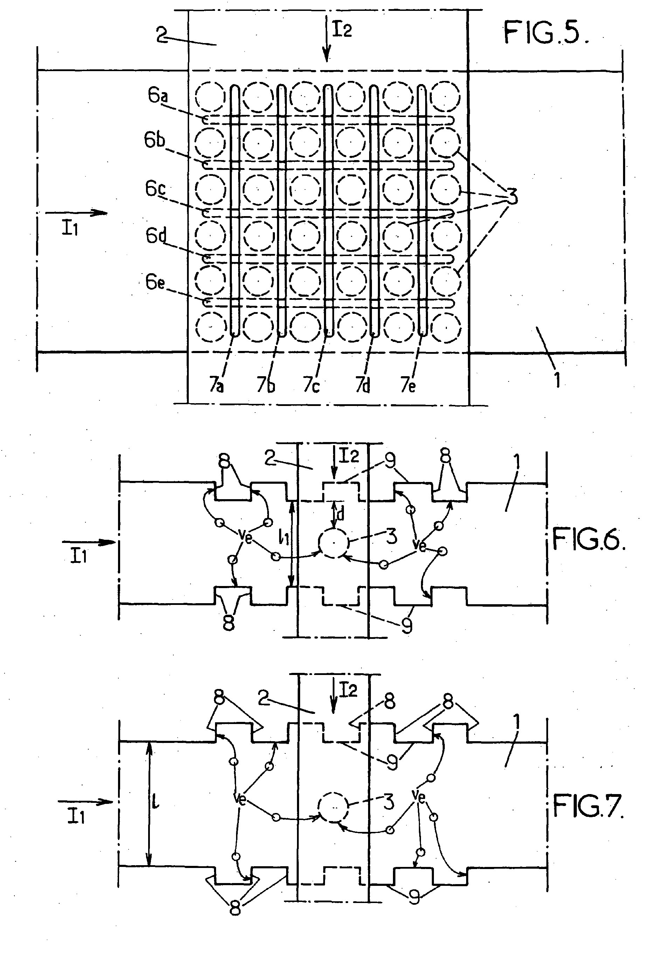

Le dispositif de connexion électrique de la figure 5 résulte d'une application du principe de la figure 4 de façon symétrique pour chacune des pistes 1 et 2. Ainsi, la piste 2 est pénétrée par au moins une nervure de matériau isolant disposée à une distance d'un raccord sensiblement inférieure à une largeur de la seconde piste au niveau de ce raccord. Sur la figure 5, cinq nervures 7a-7e sont disposées dans la piste 2. Chaque nervure est parallèle à la direction de passage I2 du courant électrique dans la piste 2 et traverse la piste 2 entre ses faces inférieure et supérieure. Des raccords 3 sont alors disposés entre les pistes 1 et 2, de sorte qu'au moins une des nervures 6a-6e sépare deux raccords quelconques au niveau de leurs interfaces respectives avec la piste 1, et de sorte qu'au moins une des nervures 7a-7e sépare deux raccords quelconques au niveau de leurs interfaces respectives avec la piste 2. Lorsque les directions de passage de courant I1 et I2 dans les pistes 1 et 2 sont sensiblement perpendiculaires entre elles, l'ensemble des raccords 3 forme une matrice intercalée ligne à ligne avec les nervures 6a-6e de la piste 1 dans la direction I2, et intercalée ligne à ligne avec les nervures 7a-7e de la piste 2 dans la direction I1.

Dans un troisième mode de mise en oeuvre illustré par la figure 6, les bords de la piste 1 sont disposés en forme de créneaux s'étendant sur toute la hauteur de la piste 1 selon la direction D qui est perpendiculaire au plan de la figure 6. Ces créneaux comprennent d'une part des faces 9 parallèles à la direction I1, qui correspondent à l'interface entre la piste 1 et le matériau isolant qui l'entoure, présente dans la configuration représentée sur la figure 1 et connue de l'art antérieur. Ils comprennent en outre des faces perpendiculaires à la direction I1, référencées 8 sur la figure 6, intercalées entre les faces 9. Les faces 8 constituent des portions d'interface supplémentaires. Certaines des portions d'interface supplémentaires 8 sont situées à une distance d du raccord 3 inférieure à la largeur I₁ de la piste 1. Elles présentent des sites de regroupement des vides élémentaires vₑ supplémentaires par rapport aux sites présents sur les faces 9. Par conséquent, la quantité de vides élémentaires vₑ qui diffusent en direction de l'interface entre le raccord 3 et la piste 1 est diminuée proportionnellement à la surface des portions d'interfaces supplémentaires apportées par la structure en créneaux, selon le principe de l'invention.

La figure 7 représente une variante de la configuration de la figure 6, dans laquelle les créneaux sont disposés à l'extérieur de la piste 1, par rapport à la largeur I de la piste 1 dans une portion de la piste 1 éloignée du raccord 3. Une telle configuration permet de conserver une largeur effective pour le passage du courant I1 constante sur toute la longueur de la piste 1.

Il est bien entendu que le troisième mode de mise en oeuvre de l'invention, consistant en la disposition de créneaux sur certaines des faces de la piste 1 dans la zone de connexion électrique de la piste 1 avec la piste 2, peut être avantageusement combiné avec le premier et/ou le second mode de réalisation.

## Revendications

1. Dispositif de connexion électrique entre une première piste conductrice (1) et une seconde piste conductrice (2) d'un circuit intégré comprenant un premier raccord conducteur (3a) entre la première piste et la seconde piste, la première piste ayant une première interface (4a) avec le premier raccord et une seconde interface avec un matériau isolant entourant latéralement la première piste, ladite seconde interface étant sensiblement parallèle à une direction de passage d'un courant électrique (I1) dans la première piste, **caractérisé en ce que** la première piste (1) comprend au moins une interface supplémentaire (6a-6f ; 8) avec un matériau isolant, disposée à une distance (d) du premier raccord sensiblement inférieure à une largeur (I₁) de la première piste au niveau de la première interface.

2. Dispositif selon la revendication 1, dans lequel l'interface supplémentaire comprend une surface d'une nervure (6a-6f) de matériau isolant comprise dans la première piste (1).

3. Dispositif selon la revendication 2, dans lequel la nervure (6a-6f) est parallèle à la direction de passage d'un courant électrique dans la première piste (I1).

4. Dispositif selon la revendication 3, dans lequel l'interface supplémentaire comprend des surfaces de plusieurs nervures (6a-6f) de matériau isolant comprises dans la première piste (1), parallèles entre elles et à la direction de passage d'un courant électrique dans la première piste (I1).

5. Dispositif selon la revendication 4, comprenant plusieurs raccords (3a-3g) entre la première piste (1) et la seconde piste (2), et dans lequel au moins deux interfaces entre la première piste et deux raccords respectifs (3) sont séparées par au moins une nervure comprise dans la première piste.

6. Dispositif selon l'une quelconque des revendications 2 à 5, dans lequel la ou les nervures (6a-6f) comprises dans la première piste (1) traversent la première piste entre deux faces opposées de la première piste, suivant une direction (D) perpendiculaire à la première piste et à la seconde piste.

7. Dispositif selon l'une quelconque des revendications précédentes, dans lequel la seconde piste (2) comprend au moins une nervure (7a-7e) de matériau isolant disposée à une distance du premier raccord sensiblement inférieure à une largeur de la seconde piste au niveau de son interface vers le premier raccord.

8. Dispositif selon la revendication 7, dans lequel la seconde piste (2) comprend plusieurs nervures (7a-7e) de matériau isolant parallèles entre elles et à une direction de passage d'un courant électrique dans la seconde piste (I2).

9. Dispositif selon la revendication 5 et la revendication 8, dans lequel au moins deux interfaces entre la seconde piste (2) et les deux raccords respectifs (3) sont séparées par au moins une nervure (7a-7e) comprise dans la seconde piste.

10. Dispositif selon l'une quelconque des revendications 7 à 9, dans lequel la ou les nervures (7a-7e) comprises dans la seconde piste (2) traversent la seconde piste entre deux faces opposées de la seconde piste.

11. Dispositif selon l'une quelconque des revendications 1 à 10, dans lequel l'interface supplémentaire comprend des faces de créneaux (8) intercalées entre des portions (9) de la seconde interface.

12. Dispositif selon la revendication 11, dans lequel les faces de créneaux (8) intercalées entre des portions (9) de la seconde interface sont sensiblement perpendiculaires à la direction de passage de courant électrique dans la première piste (I1).

13. Dispositif selon la revendication 11 ou la revendication 12, comprenant en outre un second raccord conducteur entre la première piste (1) et la seconde piste (2) disposé à une distance du premier raccord sensiblement inférieure à la largeur (I₁) de la première piste au niveau de la première interface.

14. Dispositif selon l'une quelconque des revendications 1 à 13, dans lequel le matériau isolant comprend des atomes de silicium.

15. Dispositif selon l'une quelconque des revendications 1 à 13, dans lequel le matériau isolant comprend des atomes de carbone et de fluor.

16. Dispositif selon l'une quelconque des revendications précédentes, dans lequel l'un au moins des matériaux de la première piste (1), de la seconde piste (2), du ou des raccords (3) est à base de cuivre, d'aluminium, d'argent ou d'un alliage contenant l'un au moins des métaux précédents.
